Europäisches Patentamt

European Patent Office

Office européen des brevets

(19)

(11) Numéro de publication : **0 389 383 B1**

(12) **FASCICULE DE BREVET EUROPEEN**

<table>
<tr><td>(45) Date de publication du fascicule du brevet :<br>**24.08.94 Bulletin 94/34**</td><td>(51) Int. Cl.⁵ : **G01R 19/165,** G05F 1/573</td></tr>
</table>

(21) Numéro de dépôt : **90420022.7**

(22) Date de dépôt : **16.01.90**

(54) **Dispositif et procédé de détection du passage d'un courant dans un transistor MOS.**

(30) Priorité : **20.01.89 FR 8901230**

(43) Date de publication de la demande :
**26.09.90 Bulletin 90/39**

(45) Mention de la délivrance du brevet :
**24.08.94 Bulletin 94/34**

(84) Etats contractants désignés :
**BE DE ES FR GB IT NL SE**

(56) Documents cités :
**EP-A- 0 029 767**
**WO-A-82/02262**
**US-A- 3 939 399**
**US-A- 4 021 701**

(56) Documents cités :
**US-A- 4 599 554**
**PATENT ABSTRACTS OF JAPAN, vol. 8, no.
235 (E-275)[1672], 27 octobre 1984; & JP-A-59
114 923 (HITACHI) 03-07-1984**

(73) Titulaire : **SGS-THOMSON
MICROELECTRONICS S.A.
7, Avenue Galliéni
F-94250 Gentilly (FR)**

(72) Inventeur : **Barou, Michel
2, Résidence Bouvardière
F-38340 Voreppe (FR)**

(74) Mandataire : **de Beaumont, Michel
1bis, rue Champollion
F-38000 Grenoble (FR)**

Jouve, 18, rue Saint-Denis, 75001 PARIS

## Description

La présente invention concerne le domaine des transistors MOS de puissance

De façon classique, un transistor MOS de puissance est souvent réalisé selon la technologie dite DMOS (MOS diffusé) et est composé d'un ensemble de nl cellules identiques qui lui permettent, par leur répétition, de supporter des puissances importantes. La valeur de n1 est par exemple 2500. Ce transistor MOS est généralement destiné à être relié en série à une charge.

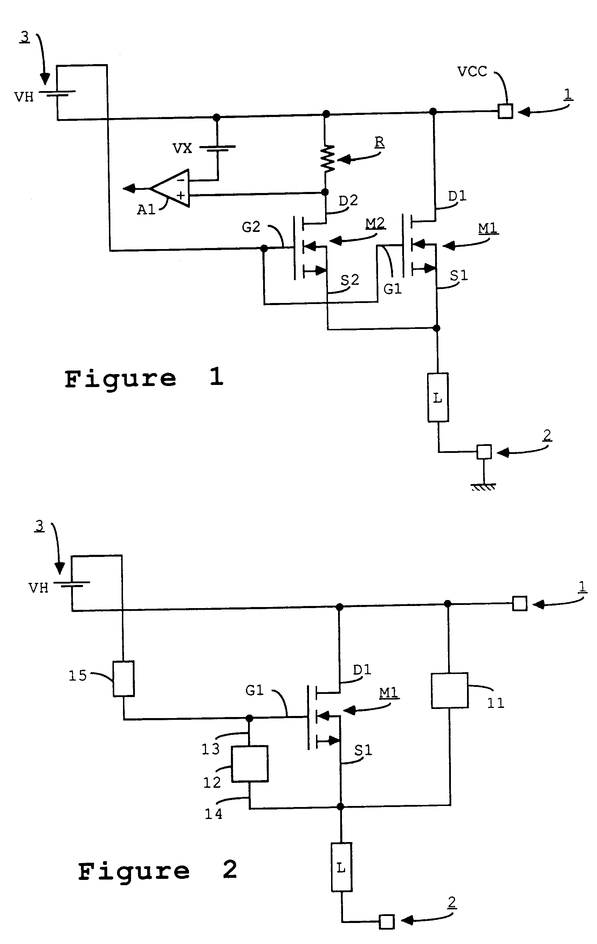

La figure 1 représente un transistor MOS de puissance M1 connecté en série, par sa source S1, à une charge L. Le drain D1 du transistor est relié à une première borne 1 d'une source d'alimentation. La borne libre de la charge L est reliée à la deuxième borne 2 de la source d'alimentation. Habituellement, une tension VCC positive est appliquée à la borne 1, la borne 2 étant connectée à la masse. Le transistor M1 est rendu passant si une tension de commande VH supérieure à la tension VCC est appliquée sur sa grille G1 par une source de commande 3.

Il peut arriver que la charge soit interrompue alors que le transistor est à l'état passant. Cette charge peut être considérée comme interrompue lorsque le courant la traversant devient inférieur à un courant seuil IA dont la valeur est par exemple IA = 3 mA. Lorsque le courant qui traverse le transistor M1 baisse à une valeur inférieure à ce courant seuil, la chute de tension VDS entre le drain et la source de ce transistor diminue et devient inférieure à 1 mV.

La demande de brevet japonais JP-A-59-114923 décrit un circuit permettant de détecter une telle interruption de charge par une mesure du courant dans la charge.

Une façon plus précise de détecter une telle interruption de charge pourrait consister à mesurer la chute de tension VDS. Pour ce faire, on utilise couramment un circuit comprenant un transistor MOS auxiliaire M2, composé par exemple de n2 = 50 cellules identiques aux n1 cellules constituant le transistor de puissance relié par son drain D2 à une résistance R dont la borne libre est connectée à la borne 1 de la source d'alimentation. La source S2 du transistor M2 est directement connectée à la source S1 du transistor M1. La grille G2 du transistor M2 est directement connectée à la grille G1 du transistor M1.

Une configuration similaire à celle qui vient d'être décrite est connue du brevet américain US-A-4 599 554. Dans ce brevet, la résistance est reliée au niveau de la source du transistor M2.

Un amplificateur opérationnel A1 compare la chute de tension aux bornes de la résistance R à une valeur de diagnostic VX. Si on appelle IL le courant dans la charge L, $I_{M1}$ le courant dans le transistor M1, $I_{M2}$ le courant dans le transistor M2, et $R_{ON1}$ et $R_{ON2}$ les résistances à l'état passant en régime linéaire des transistors M1 et M2 respectivement, la chute de tension $V_R$ aux bornes de la résistance R sera :

$$V_R = R\, I_{M2}$$
$$V_R = R\, IL\, R_{ON1} / (R_{ON1} + R_{ON2} + R)$$
$$\text{soit } V_R \text{ sensiblement égal à } R_{ON1}\, IL \quad (1)$$

En effet, on a toujours $R_{ON1}$ et $R_{ON2}$ petits devant R.

La valeur de $R_{ON1}$ est classiquement de l'ordre de quelques dizièmes d'ohm, par exemple 0,3 ohm. La tension $V_R$ est celle que l'on compare à une tension de référence. En pratique, on ne sait pas faire commodément des associations comparateurs/ tensions de référence dans lesquelles la valeur de la tension de référence est inférieure à quelques dizaines de millivolts, par exemple 30 millivolts.

Ainsi, on déduit de la relation (1) que l'on pourra détecter des passages de courant IL pour une valeur minimale de 30 mV/0,3 ohm = 100 mA.

Or on voudrait détecter des courants dans la charge de l'ordre de 3 mA.

La présente invention propose un dispositif permettant la détection de courants associés à des interruptions de charge et un procédé de détection associé.

Plus précisément, la présente invention prévoit un dispositif de détection du passage d'un courant inférieur à un courant seuil donné dans une charge en série avec un transistor MOS de puissance, la borne libre du transistor MOS étant reliée à une première borne d'une source d'alimentation dont la deuxième borne est reliée à la borne libre de la charge, la grille du transistor MOS étant reliée à une source de commande. Un moyen de détection de chute de tension est connecté aux bornes du transistor MOS et une boucle d'asservissement impose une tension de grille appropriée au transistor MOS dès que la chute de tension à ses bornes tend à descendre en dessous d'un niveau déterminé.

Selon un autre aspect de la présente invention, il est prévu un procédé de détection du passage d'un courant inférieur à un courant seuil donné dans une charge en série avec un transistor MOS de puissance alimenté par une tension déterminée. Ce procédé consiste à comparer la tension aux bornes du transistor MOS à une tension de référence et à faire diminuer la tension sur la grille du transistor MOS dès que sa tension aux bornes chute en dessous de la tension de référence, d'où il résulte que le courant dans le transistor MOS reste détectable et que le transistor MOS fonctionne dans sa région de saturation.

Ces objets, caractéristiques et avantages ainsi que d'autres de la présente invention seront exposés plus en détail dans la description suivante d'un mode de réalisation particulier faite en relation avec les figures jointes parmi lesquelles :

la figure 1, déjà décrite, représente un schéma électrique d'un dispositif de détection de courant selon l'art antérieur ;

la figure 2 représente un dispositif de détection de courant selon la présente invention ;

la figure 3 représente un mode de réalisation du dispositif de détection de courant selon la présente invention ; et

la figure 4 représente un réseau de courbes de courant dans un transistor MOS en fonction de la tension à ses bornes pour différentes valeurs de la tension appliquée sur sa grille.

La figure 2 représente un schéma électrique d'un dispositif de détection du passage d'un courant IL dans une charge L en série avec un transistor MOS de puissance M1. Comme dans le cas de la figure 1, la borne libre du transistor M1 est reliée à une première borne 1 d'une source d'alimentation et la borne libre de la charge L est reliée à la deuxième borne 2 de la source d'alimentation. Une source de commande 3, reliée à la grille G1 du transistor M1, fournit à cette grille G1 une tension de commande VH Un moyen de détection de la chute de tension aux bornes du transistor M1, ce moyen étant représenté par le bloc 11, est connecté entre le drain D1 et la source S1 du transistor M1.

Par rapport à la figure 1, le dispositif comprend en outre une boucle d'asservissement représentée par le bloc 12 dont une première borne 13 est connectée à la grille G1 du transistor M1 et une deuxième borne 14 est connectée à la source S1 de ce transistor. Un élément 15, constitué par exemple par une source de courant, est connecté entre la source de commande 3 et la grille G1 du transistor M1 afin de permettre de faire varier la tension appliquée sur cette grille G1 de sorte que la chute de tension aux bornes du transistor MOS reste toujours supérieure à une valeur déterminée.

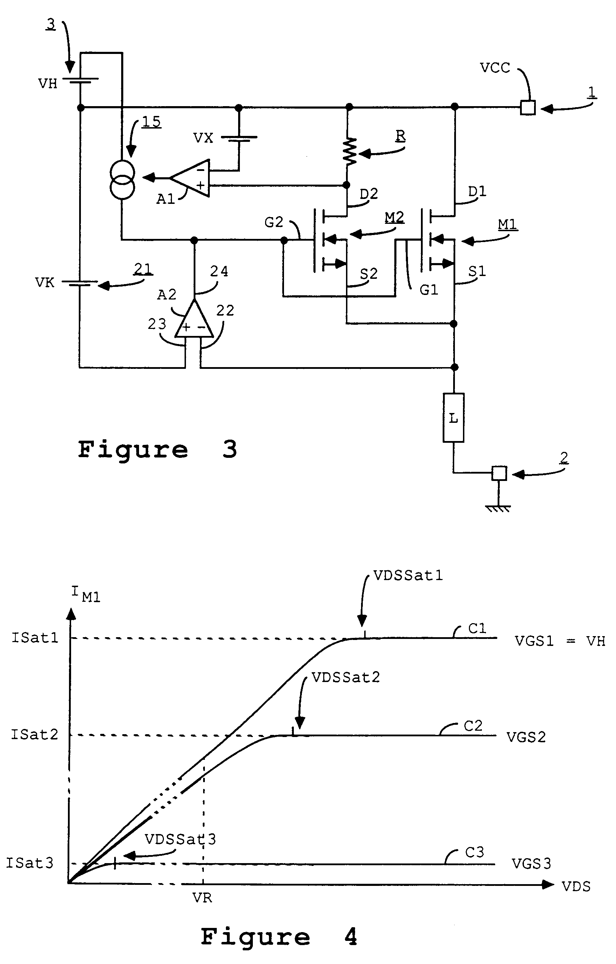

La figure 3 représente un schéma électrique d'un mode de réalisation du dispositif de détection de courant selon la présente invention. Ce schéma électrique est semblable au schéma électrique de la figure 2. Le moyen de détection de la chute de tension aux bornes du transistor M1, qui est représenté sur la figure 2 par le bloc 11, est composé d'un transistor MOS auxiliaire M2 ayant n2 cellules, d'une résistance R d'un amplificateur opérationnel A1 et d'une source de tension de diagnostic VX disposés comme ils le sont dans la figure 1. Une tension VCC positive est appliquée à la borne 1 de la source d'alimentation, la borne 2 étant connectée à la masse. L'élément 15 du schéma électrique de la figure 2 est une source de courant (une impédance).

La boucle d'asservissement, représentée sur la figure 2 par le bloc 12, est composée d'un amplificateur opérationnel A2 et d'une source de tension de référence 21. L'amplificateur opérationnel A2 comprend une première entrée 22 reliée à la source S1 du transistor M1 et une deuxième entrée 23 reliée à une première borne de la source de tension de référence 21. La deuxième borne de cette source 21 est reliée au drain D1 du transistor M1 et délivre une tension de référence VK positive. La sortie 24 de l'amplificateur opérationnel A2 est connectée aux grilles G1 et G2 des transistors M1 et M2, respectivement.

La figure 4 représente un réseau de courbes C1 à C3 du courant $I_{M1}$ entre le drain et la source du transistor M1 en fonction de la tension VDS entre le drain et la source de ce transistor. Chacune des courbes C1 à C3 correspond à une tension de grille, VGS1 à VGS3 respectivement. La tension VGS1 est égale à la tension de commande VH.

Chaque courbe est divisée en deux régions . une région de saturation pour laquelle la tension VDS est supérieure à une tension de saturation VDSSat et où le courant $I_{M1}$ est égal à un courant constant de saturation ISat, et une région sensiblement linéaire pour laquelle la tension VDS est inférieure à la tension de saturation VDSSat et où le courant $I_{M1}$ est sensiblement proportionnel à la tension VDS. Au fur et à mesure que VGS diminue, ISat et VDSSat diminuent. Les courants ISat1, ISat2 et ISat3, ainsi que les tensions VDSSat1, VDSSat2 et VDSSat3, sont associés aux courbes C1, C2 et C3, respectivement.

Lors d'une baisse du courant IL dans la charge, la tension VDS diminue. Elle devient inférieure à la tension VDSSat1. Tant qu'elle est supérieure à la tension de référence VK, l'intensité du courant $I_{M1}$ diminue sur la courbe C1.

Quand la tension VDS tend à devenir inférieure à la tension VK, l'amplificateur opérationnel A2, qui tend à maintenir ses entrées 22 et 23 au même potentiel, devient actif pour maintenir la tension VDS aux bornes du transistor M1 égale à la tension VK. Pour y parvenir, c'est-à-dire pour conserver une tension VDS notable alors que le courant $I_{M1}$ tend à diminuer, l'amplificateur opérationnel A2 fait baisser la tension VGS sur les grilles G1 et G2 à une tension telle que la tension VGS3 correspondant à la courbe C3 de la figure 4. La tension de saturation VDSSat est alors égale à la tension VDSSat3.

La tension de référence VK est par exemple égale à 150 mV. Lors des interruptions de charge, les tensions de saturation descendent à des valeurs de tension VDSSat3 de l'ordre de 50 mV nettement inférieures à VK. Ainsi, le transistor M1 fonctionne en régime de saturation. Le courant $I_{M1}$ qui le traverse est égal au courant de saturation ISat3.

Sans la boucle d'asservissement, les transistors M1 et M2 entraient en régime linéaire quand le courant dans la charge chutait.

Avec la boucle d'asservissement, puisque les transistors M1 et M2 fonctionnent en régime saturé à la suite de la chute du courant IL, les courants $I_{M1}$ et $I_{M2}$ sont reliés par la relation $I_{M1} = (n1/n2)I_{M2}$. Ainsi, puisque $IL = I_{M1}+I_{M2}$, on a :

$$IL = (n1/n2)\, I_{M2} + I_{M2}$$

soit

$$IL = [(n1/n2) + 1]I_{M2}.$$

Le courant $I_{M2}$ est relié à la tension $V_R$ aux bornes de la résistance R par la relation $I_{M2} = V_R/R$. Le courant IL est ainsi donné par

$$IL = [(n1/n2) + 1] V_R / R$$

Si l'on prend les valeurs R = 500 ohms et n1/n2 = 2500/50, c'est-à-dire n1/n2 = 50, et si l'on considère, comme valeur de tension de diagnostic au-dessus de laquelle on réalise des associations comparateurs/tensions de diagnostic convenables, la valeur 30 mV, on pourra détecter des passages de courant IL jusqu'à une valeur de (50+1)30 mV/500 ohms environ égale à 3 mA correspondant bien à la valeur du courant seuil IA.

La présente invention est susceptible de nombreuses variantes de réalisation qui apparaîtront à l'homme de l'art. Par exemple, le transistor M2, la résistance R, l'amplificateur opérationnel A1 et la source de tension de diagnostic VX pourront être remplacés par tous moyens de détection de la chute de tension aux bornes du transistor M1.

## Revendications

1. Dispositif de détection du passage d'un courant (IL) inférieur à un courant seuil (IA) donné dans une charge (L) en série avec un transistor MOS de puissance (M1), la borne libre du transistor MOS étant reliée à une première borne (1) d'une source d'alimentation dont la deuxième borne (2) est reliée à la borne libre de la charge (L), la grille (G1) du transistor MOS étant reliée à une source de comnande (3), comprenant un moyen (11) de détection de la chute de tension aux bornes du transistor MOS, caractérisé en ce qu'il comprend en outre une boucle d'asservissement (12) dont une première borne (13) est connectée à la grille (G1) du transistor MOS de puissance (M1) et une deuxième borne (14) est connectée à la source (S1) dudit transistor MOS pour diminuer la tension de grille dudit transistor MOS dès que la chute de tension à ses bornes tend à descendre en dessous d'un niveau de référence (VK) afin que le transistor MOS fonctionne dans sa region de saturation.

2. Dispositif de détection selon la revendication 1, caractérisé en ce que la boucle d'asservissement (12) est composée d'un amplificateur opérationnel (A2) et d'une source de tension de référence (21), l'amplificateur opérationnel ayant une première entrée (22) reliée à la source (S1) du transistor MOS, une deuxième entrée (23) reliée à la borne négative de la source de tension de référence dont la borne positive est reliée au drain (D1) du transistor MOS et une sortie (24) connectée à la grille (G1) du transistor MOS, une source de courant (15) étant prévue entre la sortie (24) de l'amplificateur opérationrel (A2) et la source de commande (3) pour permettre une consommation de courant dans l'amplificateur opérationnel afin d'abaisser la tension de grille du transistor MOS.

3. Dispositif de détection selon la revendication 1, caractérisé en ce que le moyen (11) de détection de la chute de tension aux bornes du transistor MOS de puissance comprend :
   - un transistor MOS auxiliaire (M2) dont la source (S2) est connectée à la source (S1) du transistor MOS de puissance et dont la grille (G2) est connectée à la grille (G1) du transistor MOS de puissance,
   - une résistance R dont une prumière borne est reliée au drain (D2) du transistor MOS auxiliaire et la deuxième borne est connectée à la première borne de la source d'alimentation, et
   - un amplificateur opérationnel (A1) et une source de tension de diagnostic (VX).

4. Procédé de détection du d'un courant (IL) inférieur à un courant seuil (IA) donné dans une charge (L) en série avec un transistor MOS de puissance (M1) alimenté par une tension déterminée (VOC), caractérisé en ce qu'il consiste à comparer la tension (VDS) aux bornes du transistor MOS (M1) à une tension de référence (VK) et à faire diminuer la tension sur la grille du transistor MOS dès que sa tension aux bornes chute en dessous de la tension de référence, d'où il résulte que le courant ($I_{M1}$) dans le transistor MOS reste détectable et que le transistor MOS fonctionne dans sa region de saturation.

5. Procédé de détection selon la revendication 4, caractérisé en ce que la tension de référence (VK) est égale à 150 mV.

## Patentansprüche

1. Detektionsvorrichtung für einen Stromfluß (IL), der kleiner als ein Schwellenstrom (IA) ist und in einer Last (L) in Reihe mit einem MOS-Leistungstransistor (M1) vorliegt, wobei der freie Anschluß des MOS-Transistors mit einem ersten Anschluß (1) einer Stormversorgung verbunden ist, deren zweiter Anschluß (2) mit dem freien Anschluß der Last (L) verbunden ist und das Gate (G1) des MOS-Transistors mit einer Steuerquelle (3) verbunden ist, welche eine Einrichtung (11) zum Detektieren des Spannungsabfalls über den Anschlüssen des MOS-Transistors umfaßt, dadurch gekennzeichnet, daß sie weiterhin einen Regelkreis (12) umfaßt, von welchem ein erster Anschluß (13) desselben mit dem Gate (G1) des MOS-Leistungstransistors (M1) verbunden ist und ein zweiter Anschluß (14) desselben mit der Source (S1) des MOS-Transistors verbunden ist, um die Gate-Spannung des MOS-Transistors zu verringern, sobald der Spannungsabfall über seinen Anschlüssen dazu neigt, ein Referenzniveau (VK) zu unterschreiten, so daß der MOS-Transistor in seinem Sättigungsbereich arbeitet.

2. Detektionsvorrichtung nach Anspruch 1, dadurch gekennzeichnet, daß der Regelkreis (12) einen Operationsverstärker (A2) und eine Referenzspannungsquelle (21) umfaßt, wobei der Operationsverstärker einen ersten Eingang (22), der mit der Source (S1) des MOS-Transistors verbunden ist, einen zweiten Eingang (23), der mit dem negativen Anschluß der Referenzspannungsquelle verbunden ist, deren positiver Anschluß mit dem Drain (D1) des MOS-Transistors verbunden ist, und einen Ausgang (24) aufweist, der mit dem Gate (G1) des MOS-Transistors verbunden ist, wobei eine Stromquelle (15) zwischen dem Ausgang (24) des Operationsverstärkers (A2) und der Steuerquelle (3) vorgesehen ist, um eine Stromaufnahme in dem Operationsverstärker zuzulassen, um die Gate-Spannung des MOS-Transistors herabzusetzen.

3. Detektionsvorrichtung nach Anspruch 1, dadurch gekennzeichnet, daß die Einrichtung (11) zum Detektieren des Spannungsabfalls über den Anschlüssen des MOS-Leistungstransistors umfaßt:
   - einen MOS-Hilfstransistor (M2), dessen Source (S2) mit der Source (S1) des MOS-Leistungstransistors verbunden ist und dessen Gate (G2) mit dem Gate (G1) des MOS-Leistungstransistors verbunden ist,
   - einen Widerstand (R), dessen erster Anschluß mit dem Drain (D2) des MOS-Hilfstransistors verbunden ist und dessen zweiter Anschluß mit dem ersten Anschluß der Stromversorgung verbunden ist, und
   - einen Operationsverstärker (A1) und eine Quelle für eine Referenzspannung (VX).

4. Detektionsverfahren für einen Stromfluß (IL) unterhalb eines Schwellenstroms (IA), der in einer Last (L) in Reihe mit einem MOS-Leistungstransistor (M1) vorliegt, der mit einer festgelegten Spannung (VCC) versorgt wird, dadurch gekennzeichnet, daß es darin besteht, die Spannung (VDS) über den Anschlüssen des MOS-Transistors (M1) mit einer Referenzspannung (VK) zu vergleichen und die Spannung an dem Gate des MOS-Transistors zu verringern, sobald seine Spannung über den Anschlüssen unter die Referenzspannung fällt, was zur Folge hat, daß der Strom ($I_{M1}$) in dem MOS-Transistor detektierbar bleibt und der MOS-Transistor in seinem Sättigungsbereich arbeitet.

5. Detektionsverfahren nach Anspruch 4, dadurch gekennzeichnet, daß die Referenzspannung (VK) gleich 150 mV ist.

## Claims

1. A device for detecting the flow of a current (IL) lower than a given threshold current (IA) in a load (L) in series with a power MOS transistor (M1), the free terminal of the MOS transistor being connected to a first terminal (1) of a supply source, the second terminal (2) of which is connected to the free terminal of the load (L), the gate (G1) of the MOS transistor being connected to a control source (3), comprising a means (11) for detecting a voltage drop across the terminals of the MOS transistor, characterized in that it further comprises a control loop (12), a first terminal (13) of which is connected to the gate (G1) of the power MOS transistor (M1) and a second terminal (14) of which is connected to the source of said MOS transistor as soon as the voltage drop across its terminals tends to decrease below a reference level (VK), so that the MOS transistor operates in its saturation region.

2. A detection device according to claim 1, characterized in that the control loop (12) is comprised of an operational amplifier (A2) and a reference voltage source (21), the operational amplifier having a first input (22) connected to the source (S1) of the MOS transistor, a second input (23) connected to the negative terminal of the reference voltage source, the positive terminal of which is connected to the drain (D1) of the MOS transistor and an output (24) connected to the gate (G1) of the MOS transistor, a current source (15) being provided for between the output (24) of the operational amplifier (A2) and the control source (3) for allowing the current to be used in the operational amplifier in order to decrease the gate voltage of the MOS transistor.

3. A detection device according to claim 1, characterized in that the means (11) for detecting the voltage drop across the terminals of the power MOS transistor comprises:
   - an auxiliary MOS transistor (M2), the source (S2) of which is connected to the source (S1) of the power MOS transistor and the gate (G2) of which is connected to the gate (G1) of the power MOS transistor,
   - a resistor R, a first terminal of which is connected to the drain (D2) of the auxiliary MOS transistor and the second terminal is connected to the first supply source terminal, and
- an operational amplifier (A1) and a reference voltage source (VX).

4. A method for detecting the flow of a current (IL) lower than a threshold current (IA) in a load (L) in series with a power MOS transistor (M1) fed by a determined voltage (VCC), characterized in that it consists in comparing the voltage (VDS) across the terminals of the MOS transistor (M1) with a reference voltage (VK) and in causing the voltage on the MOS transistor gate to decrease as soon as said voltage across the terminals drops below the reference voltage, whereby the current ($I_{M1}$) in the MOS transistor remains detectable and the MOS transistor operates in its saturation region.

5. A detection method according to claim 4, characterized in that the reference voltage (VK) is equal to 150 mV.

Figure 1

Figure 2

Figure 3

Figure 4